# FASCICULE DE BREVET EUROPEEN

(11) **EP 0 677 874 B1**
(45) Date de publication et mention de la délivrance du brevet: **19.09.2001**
(21) Numéro de dépôt: 95410030.1
(22) Date de dépôt: 11.04.1995
(51) Int. Cl.: H01L 27/02, H01L 29/74, H01L 29/87

(54) **Indicateur de défaut d'un composant de protection**
Fehlerindikator für ein Schutzbauelement
Default indicator for a protection component

(30) Priorité: 14.04.1994 FR 9404759
(43) Date de publication de la demande: 18.10.1995
(73) Titulaire: STMicroelectronics S.A., 94250 Gentilly (FR)
(72) Inventeur: Pezzani, Robert, F-37210 Vouvray (FR)
(74) Mandataire: de Beaumont, Michel

(56) Documents cités:
- EP-A- 0 542 648
- JP-A- 56 072 366
- US-A- 4 208 669
- PATENT ABSTRACTS OF JAPAN vol. 8, no. 181 (E-261) 21 Août 1984 & JP-A-59 072 766 (TOSHIBA) 24 Avril 1984

## Description

La présente invention concerne les composants de protection à quatre couches semiconductrices alternées, du type thyristor, thyristor sans gâchette ou diode de Shockley mono ou bidirectionnelle.

Divers montages utilisant de tels composants de protection et des perfectionnements de tels composants sont décrits dans les brevets et demandes de brevets de la demanderesse US-A-5274524, US-A-5243488, EP-A-490788, US-A-5272363, EP-A-542648, EP-A-561721, FR92/14793 (B1712, B1713, B1731, B1810, B1841, B1958, B2072).

Divers perfectionnements ont été apportés à ces composants pour améliorer leur fonction de protection, c'est-à-dire rendre plus précis le seuil de retournement et/ou rendre ce seuil programmable, et améliorer leur fiabilité de fonctionnement. Ainsi, ces composants de protection sont de plus en plus utilisés en raison de leurs caractéristiques de mise en conduction (la tension à leurs bornes chute à une valeur très faible pendant la durée d'une surcharge), de leur petite dimension subséquente et de leur rapidité de commutation. Ils trouvent notamment des applications dans la protection des lignes téléphoniques.

De façon connue, on peut utiliser une diode de Shockley unidirectionnelle avec un montage redresseur, ou bien une diode de Shockley bidirectionnelle montée entre les deux fils de la ligne téléphonique, ou encore un montage triangle ou étoile de diodes de Shockley, une première borne étant connectée à un premier conducteur de la ligne téléphonique, une deuxième borne étant connectée à un deuxième conducteur de la ligne téléphonique et une troisième borne étant connectée à une tension de référence, couramment la masse.

Toutefois, étant donné que les composants de protection doivent garder des dimensions raisonnables, ces composants sont prévus pour pouvoir supporter une surcharge d'énergie maximale déterminée. Au delà de cette énergie, le composant de protection risque d'être détruit. Les composants de protection sont conçus pour que cette destruction corresponde à une mise en court-circuit du composant de protection. En effet, si la destruction correspondait à une mise en circuit ouvert, c'est le circuit à protéger qui pourrait être détruit.

La présente invention vise à permettre une détection simple et rapide de la destruction d'un composant de protection à quatre couches.

L'information de destruction peut être fournie au voisinage immédiat du composant, ce qui peut être utile dans des centraux téléphoniques où un grand nombre de lignes arrivent et où il serait commode de signaler immédiatement sur un tableau si le composant associé à l'une des lignes est défectueux pour pouvoir accélérer l'opération de maintenance.

Cette information de destruction peut également être fournie à distance.

La présente invention vise aussi à permettre une détection simple et rapide de chaque mise en conduction d'un composant de protection à quatre couches.

Pour atteindre ces objets, la présente invention telle que revendiquée dans la revendication 1 prévoit de modifier un composant de protection en y rajoutant une jonction supplémentaire et d'associer à cette jonction supplémentaire un circuit de polarisation et de détection de sorte qu'un courant circule dans cette jonction quand l'une des jonctions actives du composant de protection est détruite. Alors, le système de détection traduit ce passage d'un courant en un signal d'information, par exemple un signal lumineux en utilisant une diode photo-émettrice, ou en un signal transmissible à distance par tout circuit de détection de courant et circuit de transmission associé.

Plus particulièrement, la présente invention propose un détecteur de défaut associé à un composant de protection semiconducteur à quatre couches dont l'une des couches médianes correspond à un substrat semiconducteur de faible niveau de dopage et d'un premier type de conductivité, dans lequel le composant comprend dans ce substrat, outre les diverses régions constituantes de sa fonction de protection, au moins une région supplémentaire du deuxième type de conductivité reliée à une borne de test.

Selon un mode de réalisation de la présente invention, la borne de test est connectée par l'intermédiaire d'un détecteur de courant à une source de tension à un potentiel supérieur ou inférieur, respectivement, à la tension de repos de chacune des bornes du composant selon que le substrat est de type N ou P, respectivement.

Selon un mode de réalisation de la présente invention, le composant de protection est une diode de Shockley bidirectionnelle comprenant de part et d'autre d'un substrat du premier type de conductivité des régions du deuxième type de conductivité dans lesquelles sont respectivement formées des régions du premier type de conductivité, les régions du premier type de conductivité étant sensiblement complémentaires en projection, et les régions supplémentaires sont formées dans la face supérieure de substrat en même temps que la région du type de conductivité opposé formée dans cette face supérieure du substrat.

Selon un mode de réalisation de la présente invention, le composant de protection comprend des couches propres à former un ensemble de diodes Shockley bidirectionnelles en montage triangle.

Selon un mode de réalisation de la présente invention, le composant de protection comprend des couches propres à former un ensemble de diodes Shockley bidirectionnelles en montage étoile.

Selon un mode de réalisation de la présente invention, le composant de protection comprend des couches propres à former un ou plusieurs composants de protection à tension de retournement contrôlée.

Selon un mode de réalisation de la présente invention, le détecteur de courant est une diode électro-luminescente.

Selon un mode de réalisation de la présente invention, le détecteur de défaut est associé à des moyens de comptage de nombres de surcharges.

Ces objets, caractéristiques et avantages ainsi que d'autres de la présente invention seront exposés en détail dans la description suivante de modes de réalisation particuliers faite à titre non-limitatif en relation avec les figures jointes parmi lesquelles :
la figure 1A représente une vue en coupe schématique d'un composant semiconducteur constituant une diode de Shockley bidirectionnelle ;
la figure 1B représente le symbole généralement utilisé pour désigner une diode de Shockley bidirectionnelle ;
la figure 2A est une représentation symbolique équivalente extrêmement schématique du composant de la figure 1A ;
la figure 2B représente sous forme de schéma, l'association d'un détecteur de défaut selon la présente invention au composant de la figure 1A ;
la figure 3 représente l'utilisation d'un détecteur de défaut selon la présente invention associé à un montage étoile ou triangle de diodes de Shockley bidirectionnelles ;
la figure 4 représente une vue en coupe d'une diode de Shockley bidirectionnelle modifiée selon la présente invention ;
la figure 5 représente une vue en coupe d'un composant incorporant un montage triangle de diodes de Shockley bidirectionnelles modifié selon la présente invention ;
la figure 6 représente une vue en coupe d'un composant constituant un montage étoile de diodes de Shockley bidirectionnelles modifié selon la présente invention ;
la figure 7A représente une vue en coupe d'une diode de Shockley unidirectionnelle modifiée selon la présente invention ;
la figure 7B représente le schéma équivalent du circuit de la figure 7A non-modifié ;
la figure 7C représente un autre schéma équivalent du composant de la figure 7A modifié selon la présente invention ;
la figure 8A représente un montage de diode de Shockley unidirectionnelle à diode anti-parallèle modifié selon la présente invention ;
la figure 8B représente un schéma équivalent du composant de la figure 8A avant modification selon la présente invention ;
la figure 9A représente une vue en coupe schématique d'un composant constitué d'un thyristor à tension de seuil réglé par un transistor et à diode anti-parallèle modifié selon la présente invention ; et,
la figure 9B représente un schéma équivalent du composant de la figure 9A avant modification selon la présente invention.

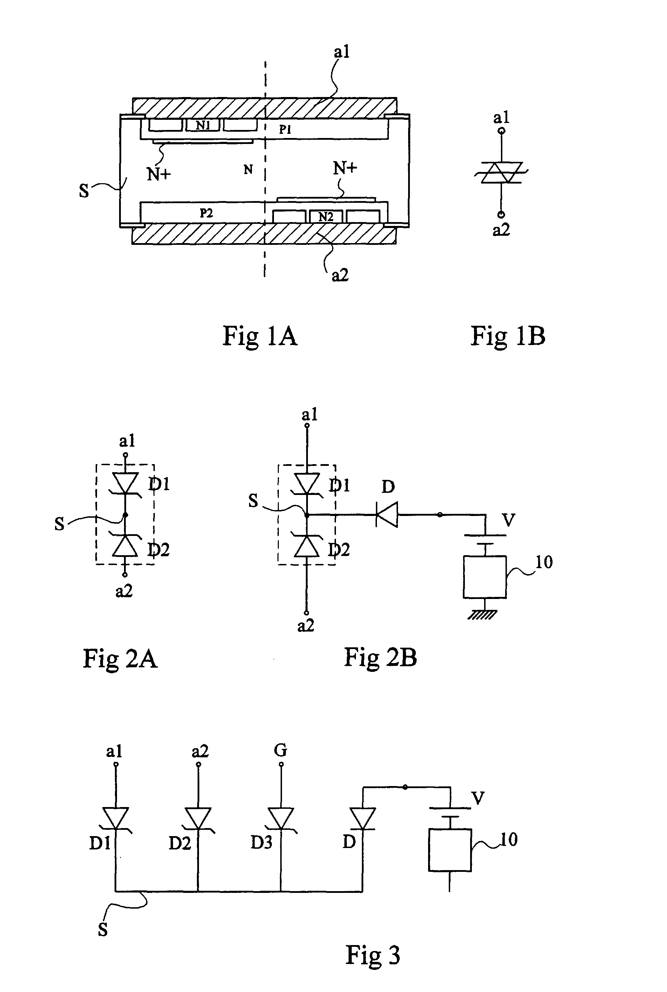

La figure 1A représente une vue en coupe d'un composant semiconducteur classique incorporant une diode de Shockley bidirectionnelle. Ce composant est constitué à partir d'un substrat S d'un premier type de conductivité, qui sera considéré ci-après comme étant le type N. A partir des faces supérieure et inférieure du substrat sont formées des régions de type P, respectivement P1 et P2. Dans environ la moitié de la surface de la région P1 est formée une région de type N, N1, et sensiblement dans la moitié de la surface de la région P2 est formée une région de type N, N2, les régions N1 et N2 étant en projection sensiblement complémentaires. Les régions N1 et N2 sont classiquement munies de trous de court-circuit (courts-circuits d'émetteur). L'ensemble des régions N1 et P1 est revêtu d'une métallisation a1 et l'ensemble des régions N2 et P2 est revêtu d'une métallisation a2. Des couches isolantes non-référencées, couramment en oxyde de silicium, sont destinées à limiter le contact entre les électrodes a1 et a2 et le substrat S. Couramment, des régions N⁺ sont disposées aux interfaces entre les régions P1 et P2 et le substrat S en vis-à-vis des régions N1 et N2, respectivement, pour fixer avec précision le seuil de déclenchement des diodes de Shockley.

La partie gauche de la figure 1A correspond à une diode de Shockley P2-S-P1-N1 dont la métallisation a2 constitue l'anode. La partie droite de la figure 1A correspond à une diode de Shockley P1-S-P2-N2 dont la métallisation a1 constitue l'anode.

Quand l'électrode a1 est positive par rapport à l'électrode a2, c'est la jonction S(N⁺)-P2 qui constitue la jonction bloquante qui entre en avalanche pour assurer une fonction de protection quand la différence de potentiel entre les électrodes a1 et a2 dépasse un seuil prédéterminé. Inversement, quand la métallisation a2 est positive par rapport à la métallisation a1, c'est la jonction S(N⁺)-P1 qui est bloquante et qui entre en avalanche quand la tension entre les électrodes a2 et a1 dépasse un seuil prédéterminé.

En cas de surcharge positive excessive sur la métallisation a1, la jonction entre le substrat S et la région P2 est susceptible d'être détruite, c'est-à-dire de demeurer en permanence passante. Inversement, en cas de surtension positive excessive sur la métallisation a2, c'est la jonction entre le substrat S et la région P1 qui risque d'être détruite et donc de rester en permanence passante.

On peut considérer que le fonctionnement statique du composant de la figure 1A correspond au schéma de la figure 2A constitué de deux diodes à avalanche D1 et D2 tête-bêche, la première correspondant à la jonction P1-S et la deuxième à la jonction S-P2. Bien entendu, cela ne doit pas faire oublier que le composant selon la présente invention, quand il rentre en régime de retournement n'a pas une caractéristique de diode à avalanche mais une caractéristique de type thyristor, c'est-à-dire que la tension à ses bornes chute à une valeur faible nettement inférieure à sa tension de retournement. Ainsi, le schéma de la figure 2A ne représente que très imparfaitement le composant de la figure 1A. Il sera toutefois utilisé pour expliquer la présente invention, étant entendu que, comme on l'a indiqué précédemment, quand le composant de la figure 1A est détruit par suite d'une surcharge, ceci équivaut à dire que l'une des diodes à avalanche D1 et D2 se met à correspondre à un court-circuit.

La présente invention propose, comme cela est illustré en figure 2B, de relier le substrat S, qui est le point commun des cathodes des diodes D1 et D2, à la cathode d'une diode de détection D polarisée positivement par une source de tension continue V en série avec un détecteur de courant 10. La source de tension V est choisie pour être positive par rapport au potentiel de repos des métallisations a1 et a2. Par exemple, dans le cas où la double diode de Shockley est destinée à protéger une ligne téléphonique, la borne a1 est à un potentiel de -48 V et la borne a2 à un potentiel voisin de celui de la masse, généralement légèrement négatif. Ainsi, il suffit que la tension V soit légèrement positive pour que, si l'une ou l'autre des diodes D1 et D2 est court-circuitée, un courant circule dans la diode D. Ce courant est détecté par le détecteur 10 qui fournit un signal d'alarme éventuellement par l'intermédiaire d'un circuit de transmission à distance. Dans une réalisation simple, le détecteur 10 est une diode électroluminescente disposée au voisinage immédiat du composant pour signaler la mise en défaut.

Les polarités indiquées ci-dessus pour la diode D et la source de tension V dépendent du type de conductivité du substrat S. Dans le cas où ce substrat serait de type P, les diodes D1 et D2 auraient la polarité opposée ainsi que la diode D et le potentiel V devrait être plus négatif que le potentiel de repos des bornes a1 et a2.

Pour mettre en oeuvre la présente invention, on pourrait prévoir sur le composant de la figure 1A une prise de contact avec le substrat et une diode externe.

Selon un aspect de la présente invention, il est prévu d'intégrer la diode D dans le composant de la figure 1A comme on le verra ci-après.

Plus généralement, la présente invention s'applique à divers types de montages comportant sous forme monolithique au moins une diode de Shockley.

La figure 3 représente un schéma équivalent simplifié, du même type que celui de la figure 2A d'un montage de diodes de Shockley bidirectionnelles en étoile ou en triangle. Les jonctions bloquantes susceptibles de rentrer en avalanche correspondent à des diodes zener D1, D2, D3 disposées entre des bornes a1, a2 et G et le substrat S. La diode D est reliée à ce substrat S. Classiquement, la borne G est reliée à la masse. On assure ainsi une protection contre une surtension entre les conducteurs a1 et a2 ou contre une surtension entre l'un de ces conducteurs et la masse.

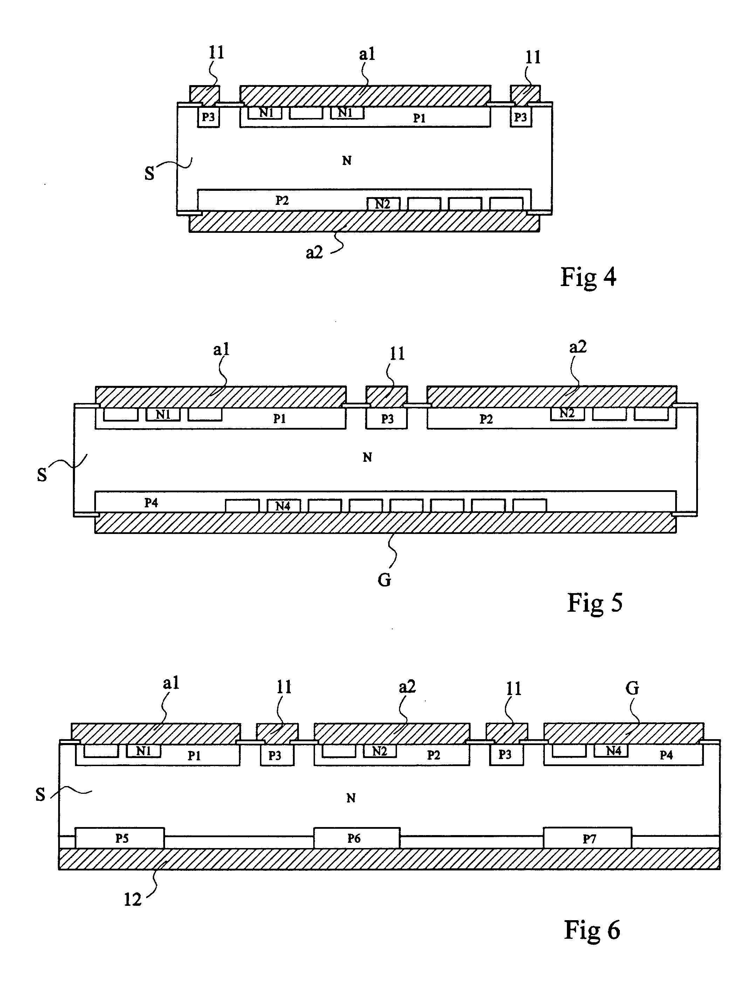

La figure 4 représente une vue en coupe schématique d'une diode de Shockley bidirectionnelle similaire à celle de la figure 1A dans laquelle a été intégrée une diode D selon la présente invention. Dans cette figure, de mêmes éléments qu'en figure 1A sont désignés par les mêmes références. Les régions N⁺ n'ont pas été représentées. Des régions de type P, P3, sont formées dans la face supérieure de substrat, en même temps que la région P1 et ces régions P3 forment avec le substrat S la diode D. Une ou plusieurs régions P3 peuvent être prévues. Des métallisations 11 solidaires de ces régions P3 correspondent à l'anode de la diode D et constituent une borne de test susceptible d'être reliée à un circuit de polarisation et de détection de courant.

La figure 5 illustre une application de la présente invention à la formation d'un réseau de diodes de Shockley bidirectionnelles en montage triangle. Dans la face supérieure du substrat sont formées des régions P1 et P2. Dans la face inférieure est formée une région P4. Des régions N1 et N2 occupent respectivement sensiblement la moitié de la surface supérieure des régions P1 et P2. Une région N4 occupe sensiblement la moitié de la surface de la région P4, la région N4 étant sensiblement complémentaire en projection des régions N1 et N2. Une première diode Shockley bidirectionnelle verticale est constituée par les régions N1-P1-S-P4-N4 entre les métallisations a1 et G, une deuxième diode de Shockley bidirectionnelle verticale est constituée par les régions N2-P2-S-P4-N4 entre les métallisations a2 et G et une troisième diode de Shockley bidirectionnelle latérale est constituée par les régions N1-P1-S-P2-N2 entre les métallisations a1 et a2. Le composant selon la présente invention comprend en outre une région P3, similaire aux régions P1 et P2, formée dans la face supérieure du substrat. A nouveau, on pourra prévoir plusieurs régions P3 réparties de façon que la résistance d'accès entre la diode P3-S et la jonction susceptible d'avoir été détruite soit minimisée.

La figure 6 représente une configuration à trois diodes de Shockley bidirectionnelles en montage étoile. Trois régions P1, P2, P4 sont formées dans la surface supérieure du substrat S. Des régions P5, P6, P7 sont formées en regard de régions N1, N2 et N4, respectivement formées dans les régions P1, P2 et P4. Chacune des régions N1, N2, N4 occupe sensiblement la moitié de la surface de chacune des régions P1, P2 et P4. La face arrière est revêtue d'une métallisation 12 non-connectée à une électrode externe. Un tel montage a déjà été décrit dans les brevets et demandes de brevet susmentionnés. Selon la présente invention, on rajoute des régions diffusées P3 dans la surface supérieure du substrat, ces régions P3 formant avec le substrat S la diode D selon l'invention.

On notera que la présente invention ne s'applique pas seulement à des systèmes à diodes de Shockley bidirectionnelles, mais aussi à d'autres systèmes de protection à quatre couches.

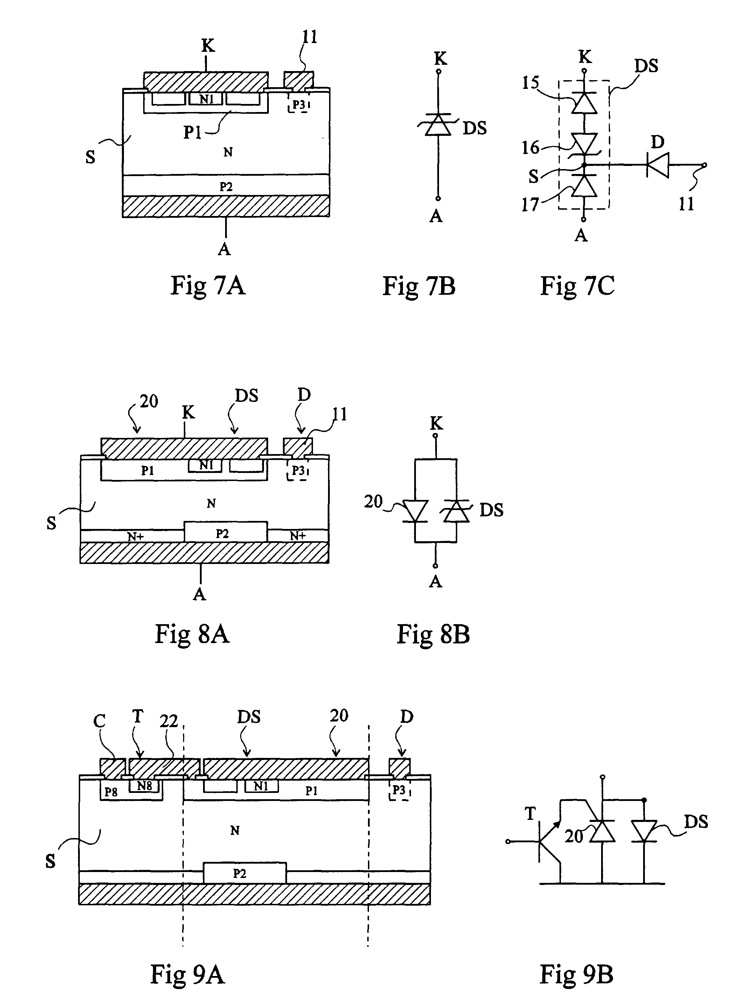

La figure 7A représente une diode de Shockley unidirectionnelle constituée à partir d'un substrat S de type N dont la face inférieure comporte une couche de type P, P2, et dont la surface supérieure comprend une région de type P, P1, dans laquelle est formée une région de type N, N1, classiquement munie comme les précédentes de trous de court-circuit. La région N1 est revêtue d'une métallisation de cathode K et la face inférieure est revêtue d'une métallisation d'anode A. Le symbole classique d'une telle diode de Shockley unidirectionnelle DS est représenté en figure 7B. Comme le représente la figure 7C, cette diode de Shockley peut se figurer comme étant constituée entre ses bornes K et A d'une diode 15, correspondant à la jonction N1-P1, d'une diode à avalanche 16 correspondant à la région P1-S et d'une diode 17 correspondant à la jonction S-P2. Selon l'invention, on propose d'ajouter une diode D reliée au substrat S. Cette diode D est constituée par une région P3 formée dans la surface supérieure et solidaire d'une métallisation de test 11.

La figure 8A représente le cas où le composant à quatre couches est constitué d'une diode de Shockley unidirectionnelle DS en anti-parallèle sur une diode 20. La face supérieure du substrat S de type N comprend une région de type P, P1, dont sensiblement la moitié de la surface est occupée par une région de type N, N1, munie de courts-circuits d'émetteur. Sur la face arrière, en face de la région N1, est formée une région P2, le reste de la face arrière étant surdopé de type N (N⁺). On obtient donc bien une diode de Shockley unidirectionnelle correspondant aux régions P2-S-P1-N1 et une diode en anti-parallèle constituée des régions P1-N-N⁺. Une région de type P, P3, est formée dans la face supérieure pour constituer avec le substrat S la diode D selon l'invention.

La figure 9A correspond à une réalisation du circuit illustré en figure 9B. Sa partie centrale est sensiblement identique à la partie principale du composant de la figure 8A. Cette fois-ci, le système à quatre couches N1-P1-S-P2 constitue un thyristor car une métallisation de gâchette 22 est solidaire de la couche P1 et est reliée à une région N8 formée dans un caisson P8. Le caisson P8 est relié à une borne de commande C qui, de façon connue, permet de fixer le seuil de déclenchement en avalanche du thyristor N1-P1-S-P2. Une région P3 est formée dans la face supérieure du substrat S pour constituer avec ce substrat la diode D selon l'invention.

Ce qui précède ne constitue que des exemples particuliers d'application de la présente invention. On pourra combiner les schémas des figures 5 et 6 avec les réalisations de composants des figures 8 et 9. Egalement, des montages plus complexes de diodes de Shockley ou de thyristors à tension de retournement contrôlée pourront être réalisés sur un même substrat S.

Le détecteur de défaut selon l'invention permet d'indiquer l'existence d'un défaut permanent, c'est-à-dire la mise en court-circuit définitive d'une jonction. De plus, un courant circule dans la diode D lors de chaque passage d'une surcharge dans le composant de protection. Ainsi, le détecteur selon l'invention peut être associé à un système logique permettant de compter le nombre de déclenchements du composant de protection auquel il est associé, ce qui peut être utile pour la gestion du circuit à protéger ou de la ligne auquel ce circuit est connecté. En effet, cela pourra amener le personnel d'entretien à s'interroger sur le type et la fréquence des défauts et éventuellement à prévoir des mesures pour pallier ces défauts. De plus, la réalisation d'un circuit logique d'analyse des déclenchements est simplifiée du fait que l'une des bornes du détecteur 10 peut être connectée à la masse.

## Revendications

1. Détecteur de défaut de type court-circuit permanent d'une jonction dans un composant de protection semiconducteur à quatre couches semiconductrices alternées dont l'une des couches médianes correspond à un substrat semiconducteur (S) de faible niveau de dopage et d'un premier type de conductivité, **caractérisé en ce que** le composant comprend dans ce substrat, outre les diverses régions constituantes de sa fonction de protection, au moins une région supplémentaire (P3) du deuxième type de conductivité reliée à une borne de test.

2. Méthode d'utilisation du détecteur de défaut selon la revendication 1, **caractérisé en ce que** ladite borne de test (11) est connectée par l'intermédiaire d'un détecteur de courant (10) à une source de tension à un potentiel (V) supérieur ou inférieur, respectivement, à la tension de repos de chacune des bornes du composant selon que le substrat est de type N ou P, respectivement.

3. Détecteur de défaut selon la revendication 1, dans lequel le composant de protection est une diode de Shockley bidirectionnelle comprenant de part et d'autre d'un substrat (S) du premier type de conductivité des régions (P1, P2) du deuxième type de conductivité dans lequel sont respectivement formées des régions du premier type de conductivité (N1, N2), les régions du premier type de conductivité (N1, N2) étant sensiblement complémentaires en projection, **caractérisé en ce que** les régions supplémentaires sont formées dans la face supérieure de substrat en même temps que la région du type de conductivité opposé (P1) formée dans cette face supérieure du substrat.

4. Détecteur de défaut selon la revendication 1, **caractérisé en ce que** le composant de protection comprend des couches propres à former un ensemble de diodes Shockley bidirectionnelles en montage triangle.

5. Détecteur de défaut selon la revendication 1, **caractérisé en ce que** le composant de protection comprend des couches propres à former un ensemble de diodes Shockley bidirectionnelles en montage étoile.

6. Détecteur de défaut selon la revendication 1, **caractérisé en ce que** le composant de protection comprend des couches propres à former un ou plusieurs composants de protection à tension de retournement contrôlée (T, 20).

7. Méthode de utilisation du détecteur de défaut selon la revendication 2, **caractérisé en ce que** le détecteur de courant est une diode électro-luminescente.

8. Méthode de utilisation du détecteur de défaut selon la revendication 2, **caractérisé en ce qu'**il est associé à des moyens de comptage de nombres de surcharges.

## Patentansprüche

1. Detektor zum Nachweis eines Fehler-bzw. Störzustands vom Typ eines p/n-Übergang-Kurzschlußes in einem Halbleiter-Schutzbauteil mit vier alternierenden Halbleiterschichten, von welchen eine der Mittelschichten einem Halbleitersubstrat (S) niedrigen Dotierungspegels und von einem ersten Leitfähigkeitstyp entspricht, **dadurch gekennzeichnet**, daß das Bauteil in dem Substrat außer den verschiedenen seine Schutzfunktion konstituierenden Bereichen wenigstens einen zusätzlichen Bereich (P3) vom zweiten Leitfähigkeitstyp aufweist, der mit einem Test-bzw. Prüfanschluß verbunden ist.

2. Verfahren zur Verwendung des Fehler- bzw. Stördetektors nach Anspruch 1, **dadurch gekennzeichnet, daß** der Test-bzw. Prüfanschluß über einen Stromdetektor (10) mit einer Spannungsquelle verbunden ist, deren Potential (V) größer bzw. kleiner als die Ruhespannung jedes der Anschlüsse des Bauteils ist, je nachdem das Substrat vom N- bzw. vom P-Typ ist.

3. Fehler- bzw. Stördetektor nach Anspruch 1, in welchem das Schutzbauteil eine bidirektionelle oder Zweirichtungs-Shockleydiode ist, welche zu beiden Seiten eines Substrats (S) eines ersten Leitfähigkeitstyps Bereiche (P1,P2) des zweiten Leitfähigkeitstyps aufweist, in welchen jeweils Bereiche (N1,N2) des ersten Leitfähigkeitstyps ausgebildet sind, wobei die Bereiche (N1,N2) des ersten Leitfähigkeitstyps in Projektion im wesentlichen komplementär zueinander sind, **dadurch gekennzeichnet, daß** die zusätzlichen Bereiche in der Oberseite des Substrats zur gleichen Zeit wie der in dieser Oberseite des Substrats ausgebildete Bereich (P1) des entgegengesetzten Leitfähigkeitstyps ausgebildet werden.

4. Fehler- bzw. Stördetektor nach Anspruch 1, **dadurch gekennzeichnet, daß** das Schutzbauteil geeignete Schichten zur Bildung eines Aggregats von Zweirichtungs-Shockleydioden in Dreiecks- bzw. Deltaschaltung aufweist.

5. Fehler- bzw. Stördetektor nach Anspruch 1, **dadurch gekennzeichnet, daß** das Schutzbauteil geeignete Schichten zur Bildung eines Aggregats von Zweirichtungs-Shockleydioden in Sternschaltung aufweist.

6. Fehler- bzw. Stördetektor nach Anspruch 1, **dadurch gekennzeichnet, daß** das Schutzbauteil geeignete Schichten zur Ausbildung eines oder mehrerer Schutzbauteile mit gesteuerter Kippspannung (T, 20) aufweist.

7. Verfahren zur Verwendung des Fehler- bzw. Stördetektors nach Anspruch 2, **dadurch gekennzeichnet, daß** der Stromdetektor eine Elektrolumineszenz-Diode ist.

8. Verfahren zur Verwendung des Fehler- bzw. Stördetektors nach Anspruch 2, **dadurch gekennzeichnet, daß** der Detektor Mitteln zum Zählen der Anzahl von Überlastzuständen zugeordnet ist.

## Claims

1. Detector of a failure of the junction shortcircuit type associated with a semiconductor protection component having four alternate semiconductor layers, one of the middle layers of which corresponds to a low-doped semiconductor substrate (S) of a first conductivity type, **characterized in that** the component includes in said substrate, in addition to the various regions providing its protection function, at least one additional region (P3) of the second conductivity type connected to a test terminal.

2. Method of use of the failure detector of claim 1, **characterized in that** the test terminal (11) is connected through a current detector (10) to a voltage source having a higher or lower voltage (V), respectively, than the quiescent voltage of each terminal of the component, depending on whether the substrate is of the N-type or P-type, respectively.

3. The failure detector of claim 1, in which the protection component is a bidirectional Shockley diode including, on both sides of a substrate (S) of a first conductivity type, regions (P1, P2) of the second conductivity type in which regions (N1, N2) of the first conductivity type are formed, respectively, the regions (N1, N2) of the first conductivity type being substantially complementary in projection, **characterized in that** said additional regions are formed in the upper surface of the substrate at the same time as said region (P1) of the opposite conductivity type formed in said upper surface of the substrate.

4. The failure detector of claim 1, **characterized in that** the protection component includes layers adapted to form a plurality of delta-connected bidirectional Shockley diodes.

5. The failure detector of claim 1, **characterized in that** the protection component includes layers adapted to form a plurality of star-connected bidirectional Shockley diodes.

6. The failure detector of claim 1, **characterized in that** the protection components includes layers adapted to form one or more protection components (T, 20) having a controlled breakover voltage.

7. Method of use of the failure detector of claim 2, **characterized in that** the current detector is a lightemitting diode.

8. Method of use of the failure detector of claim 2, **characterized in that** it is associated with a circuitry for counting the number of surges.
